# EUROPEAN PATENT SPECIFICATION

(11) **EP 3 368 218 B1**
(45) Date of publication and mention of the grant of the patent: **01.04.2020**
(21) Application number: 15907548.0
(22) Date of filing: 30.10.2015
(51) Int. Cl.: B01L 3/00, G03F 7/00, B29C 35/08

(54) **MICROFLUIDIC CHANNEL FILTER**
MIKROFLUIDISCHER KANALFILTER
FILTRE DE CANAUX MICROFLUIDIQUES

(43) Date of publication of application: 05.09.2018
(73) Proprietor: Hewlett-Packard Development Company, L.P., Spring TX 77389 (US)
(72) Inventor: BARCELO, Steven, Palo Alto, California 94304-1100 (US); GE, Ning, Palo Alto, California 94304-1100 (US); ROGACS, Anita, Palo Alto, California 94304-1100 (US)
(74) Representative: Haseltine Lake Kempner LLP
(86) International application number: PCT/US2015/058477
(87) International publication number: WO 2017/074464

(56) References cited:
- US-A1- 2002 098 124
- US-A1- 2003 136 451
- US-A1- 2004 053 422
- US-A1- 2011 076 353
- US-A1- 2012 009 098
- US-A1- 2012 009 098
- US-A1- 2014 256 047
- US-B1- 9 161 456
- US-B2- 8 636 022
- US-B2- 8 636 022
- MOORTHY J ET AL: "IN SITU FABRICATED POROUS FILTERS FOR MICROSYSTEMS", LAB ON A CHIP, ROYAL SOCIETY OF CHEMISTRY, vol. 3, no. 2, 1 May 2003 (2003-05-01), pages 62-66, XP009058699, ISSN: 1473-0197, DOI: 10.1039/B300450C

## Description

### BACKGROUND

Lab-on-a-chip (LOC) devices enable the scaling down of laboratory functions to a miniaturized environment. LOC devices can integrate several laboratory functions on a single chip that processes very small volumes of fluid. Thus, the realization of LOC devices involves the integration of a variety of components into a very small form factor. US 2012/009098 A1 relates to a microfluidic device with a filter and suggests that the filter may be formed into the substrate and with the substrate by embossing. US 8,636,022 B2 relates to the production of microfluidic polymeric devices by photo-assisted and/or thermally assisted imprinting of a polymerizable and/or crosslinkable liquid composition. Moorthy J Et Al discloses "In situ fabricated porous filters for microsystems" in Lab on a Chip, Royal Society of Chemistry, vol. 3, no. 2, 1 May 2003 (2003-05-01), pages 62-66; in this article, a porous filter is fabricated inside a microchannel through the steps of agitating a pre-polymer mixture to form an emulsion, positioning the emulsion in a predefined location within the microchannel, and photo-polymerizing the emulsion at the predefined location to form the filter.

### BRIEF DESCRIPTION OF THE DRAWINGS

Examples will now be described with reference to the accompanying drawings, in which:
FIG. 1 shows a side view of an example substrate that has an example imprintable material deposited in an example microfluidic channel formed in the substrate;
FIG. 2 shows a side view of an example substrate with an example microfluidic channel and an imprint stamp during curing of an imprintable material;
FIG. 3 shows a side view of an example substrate with a microfluidic channel after curing of an imprintable material;
FIG. 4 shows a side view of an example of a microfluidic chip after the formation of an example microfluidic channel filter and the placement of a chip top over the microfluidic channel and filter;
FIG. 5 shows a top view of an example substrate that has an example microfluidic channel formed therein;
FIG. 6 shows a flow diagram of an example method that parallels an imprint process illustrated in FIGs. 1 - 4;
FIG. 7 shows a flow diagram of an alternate example method that illustrates additional details of the imprint process illustrated in FIGs. 1 - 4;
FIG. 8 shows a flow diagram of an alternate example method that parallels the imprint process illustrated in FIGs. 1 - 4.

Throughout the drawings, identical reference numbers designate similar, but not necessarily identical, elements.

### DETAILED DESCRIPTION

Lab-on-a-chip (LOC) devices are used in different life science industries for a variety of purposes such as biomedical diagnostics, drug development, DNA replication, and so on. Laboratory functions performed on LOC devices often rely on different upstream fluid sample preparations. Preparing samples can involve the mixing of fluids, the filtering of fluids, the heating of fluids, combinations thereof, and so on. Microfluidics involves the manipulation and control of such fluids within the miniaturized LOC environments through the integration and implementation of a variety of components into a very small form factor.

Many microfluidic applications involve upstream filtration of fluid samples prior to downstream analysis of the fluid. The accuracy of some substance detection mechanisms, for example, can depend on the removal of unwanted particles from a fluid sample. Efforts toward integrating microfilters into the microfluidic channels of LOC and other microfluidic devices are ongoing. One prior method of integrating a filter into a microfluidic device, for example, involves packing very small, nano/micro particles into a microfluidic channel. The size of the nano/micro particles can be selected to trap certain targeted species such as cells and molecules of a known size. Other types of microfluidic filters include, for example, membrane filters, electrokinetic filters, and fiber filters. Filter characteristics, such as the particle filtration size, can be difficult to control with such filters. In addition, such filters are often built first and then integrated into the microfluidic device. This incorporation step adds complication to the assembly process.

Accordingly, examples of a microfluidic channel filter and methods of fabricating a microfluidic channel filter are described herein. In various examples, a micro/nanoporous filter is built into a microfluidics channel to enable simplified sample preparation for downstream processing. A nanoimprinting fabrication method allows integration of the filter directly into a microchannel without complicated processing. Filter parameters such as pore size and density can be directly patterned and reliably replicated using the nanoimprint lithography fabrication method. The use of imprint lithography enables the reliable fabrication of numerous filters having consistent parameters, which assures repeatable filter performance across the filters.

A microfluidic channel filter, or a series of such filters, can be fabricated on a microfluidics chip by a nanoimprinting method comprising several simple operations. In an example implementation, one operation of such a method includes depositing an imprintable material such as an ultra-violet (UV) or thermally curable polymer, in a region or regions of a microchannel or microchannels on a microfluidics device. In another operation, an imprint stamp with a desired filter feature topology is aligned to the device, and the two pieces are pressed together. In another operation, the deposited material is cured and the stamp is removed, which leaves behind the desired filter pore structure.

In another example implementation, a microfluidic channel filter includes a substrate, and a microfluidic channel formed in the substrate. The filter also includes an imprintable polymer material deposited in the microfluidic channel and imprinted with a filter pattern.

In another example implementation, an example method of fabricating a microfluidic channel filter includes jetting a photo-curable liquid resist into a localized area of a microfluidic channel. An imprint stamp is then pressed into the liquid resist, and ultra-violet light is applied to the liquid resist until the liquid resist is cured. The method includes removing the imprint stamp from the cured liquid resist, leaving behind a filter pattern from the imprint stamp in the cured liquid resist.

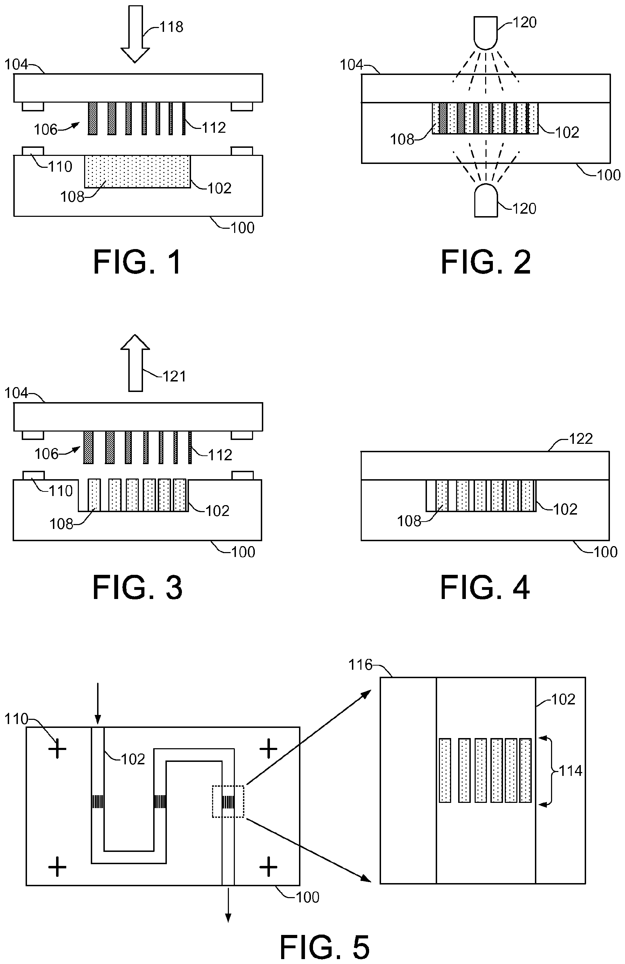

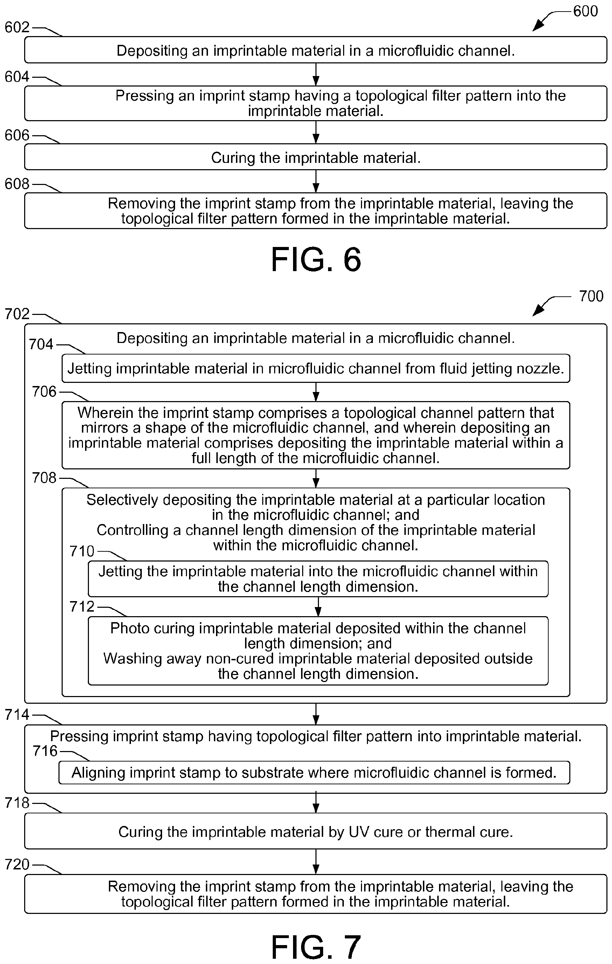

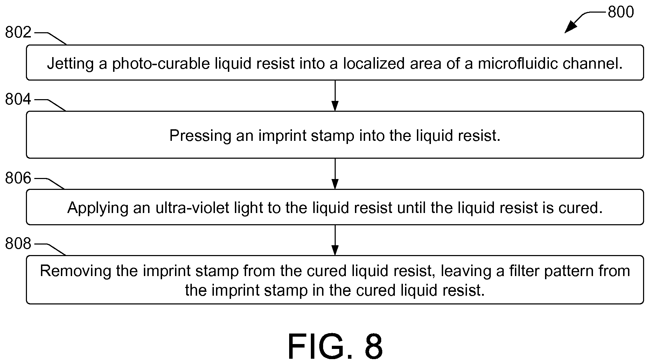

FIGs. 1 - 4 illustrate an example process for fabricating a microfluidic channel filter into a microfluidic channel of a microfluidic chip, such as a lab-on-a-chip (LOC), or a filter block chip, using nanoimprint lithography. FIG. 6 is a flow diagram of an example method 600 that parallels the process illustrated in FIGs. 1 - 4. FIG. 7 is a flow diagram of an alternate example method 700 that illustrates additional details of the process illustrated in FIGs. 1 - 4. FIG. 8 is a flow diagram of an alternate example method 800 that parallels the process illustrated in FIGs. 1 - 4.

FIG. 1 shows a side view of a substrate 100 that has a microfluidic channel 102 formed therein. The substrate 100 can comprise the substrate of a chip, such as the substrate of a lab-on-a-chip (LOC) or a filter block chip, for example. A filter block chip is a chip that provides filtering of fluid flowing through a microfluidic channel 102. The filter block chip can be inserted into the flow of fluid flowing into a lab-on-a-chip, for example, to provide upstream fluid sample preparation for laboratory functions being performed on the LOC. Also shown in FIG. 1 is an imprint stamp 104 that comprises a three-dimensional topology or profile that forms the shape of a filter pattern 106. The substrate 100 and imprint stamp 104 can be formed of various materials including silicon and fused silica (quartz), for example. One and/or the other of the substrate 100 and the imprint stamp 104 can be formed of fused silica in order to remain transparent to enable ultra-violet (UV) curing of an imprintable polymer material 108 deposited in the microfluidic channel 102. The substrate 100 and imprint stamp 104 both include alignment marks 110 to facilitate alignment with one another. The filter pattern 106 of the imprint stamp 104 is formed by finger-like protrusions 112 extending from and integrated with the imprint stamp 104.

Referring now primarily to FIG. 1 and the flow diagrams of FIGs. 6 -8, a nanoimprint process/method for fabricating a microfluidic channel filter into the microfluidic channel 102 can begin with depositing an imprintable material 108 into the channel (FIG. 6, block 602; FIG. 7, block 702). The imprintable material 108 can comprise a photo or thermal curable polymer resist, and in some examples comprises a jettable liquid polymer resist. Thus, deposition of the imprintable material 108 can include jetting the imprintable material 108 into the microfluidic channel from a fluid jetting nozzle (FIG. 7, block 704; FIG. 8, block 802). An example of a suitable fluid jetting nozzle can include an inkjet printing nozzle.

In some examples, deposition of an imprintable material 108 can include depositing the imprintable material within a full length of the microfluidic channel (FIG. 7, block 706). In such examples, in addition to forming a filter pattern 106, the imprint stamp 104 can form a pattern that mirrors the shape of the microfluidic channel 102. In other examples, deposition of an imprintable material 108 can include selectively depositing the imprintable material at a particular location within the microfluidic channel, and controlling a channel length dimension 114 (FIG. 5) of the imprintable material within the microfluidic channel (FIG. 7, block 708).

FIG. 5 shows a top view of substrate 100 that has a microfluidic channel 102 formed therein. FIG. 5 also includes a blow up view 116 of a portion of the microfluidic channel 102. In FIG. 5, the channel length dimension 114 comprises a length within the channel 102 into which the imprintable material 108 can be deposited and/or constrained. That is, the deposited imprintable material 108 will not extend beyond the channel length dimension 114. The location of the imprintable material within the channel length dimension 114 can be achieved, for example, by the precise jetting of the material into the dimension 114 (FIG. 7, block 710), or by photo curing imprintable material that has been deposited within the channel length dimension, and then washing away (e.g., with a chemical bath) non-cured imprintable material that has been imprecisely deposited outside of the channel length dimension (FIG. 7, block 712).

After the imprintable material 108 is deposited in the microfluidic channel 102, the nanoimprint process/method for fabricating a microfluidic channel filter into the microfluidic channel 102 can continue with pressing the imprint stamp 104 having a topological filter pattern 106 into the imprintable material 108 (FIG. 6, block 604; FIG. 7, block 714; FIG. 8, block 804). This is indicated in FIG. 1, by the direction arrow 118. Before pressing the imprint stamp 104 into the imprintable material 108, the alignment marks 110 on the imprint stamp 104 and substrate 100 can be used to align the stamp 104 and substrate 100 (FIG. 7, block 716) so that the filter pattern 106 is pressed into the imprintable material 108 at precisely the same location each time.

Referring now also to FIG. 2, while pressing the imprint stamp 104 into the imprintable material 108, the imprintable material is cured (FIG. 6, block 606; FIG. 7, block 718; FIG. 8, block 806). The cure can be a thermal cure or a UV cure (FIG. 7, block 718). Thus, heat or UV light 120 can be applied to the imprintable material 108 until it is cured. As noted above with reference to FIG. 1, one or the other of the substrate 100 and the imprint stamp 104 can be formed of a transparent material such as fused silica (quartz) in order to enable ultra-violet (UV) curing of the imprintable polymer material 108 deposited in the microfluidic channel 102. Thus, UV light 120 can come through either the substrate 100 or the imprint stamp 104 to cure the imprintable polymer material 108. In some examples, the UV light source 120 can comprise a heat source in the event the imprintable polymer material 108 is thermally curable instead of UV curable.

Referring now also to FIG. 3, after the cure is complete, the imprint stamp 104 is removed from the imprintable material 108 as indicated by direction arrow 121. Removal of the imprint stamp leaves the topological filter pattern 106 of the imprint stamp 104 formed into the imprintable material 108 as the microfluidic channel filter (FIG. 6, block 608; FIG. 7, block 720; FIG. 8, block 808). Referring to FIG. 4, a chip top 122 is put on the substrate 100 over the microfluidic channel 102.

The example microfluidic channel filter disclosed here is easy to fabricate and incorporate in a microchannel, simplifying integration with a lab-on-a-chip. The use of nanoimprint lithography as discussed herein enables the repeatable replication of a microfluidic channel filter with a given pore design and resolution. The potential resolution using this method is below 10 nm (nanometer).

## Claims

1. A method (600, 700, 800) of fabricating a microfluidic channel filter, comprising:
depositing (602, 702, 802) an imprintable material in a microfluidic channel;
pressing (604, 714, 804) an imprint stamp having a topological filter pattern into the imprintable material;
curing (606, 718, 806) the imprintable material; and
removing (608, 720, 806) the imprint stamp from the imprintable material, leaving the topological filter pattern formed in the imprintable material.

2. A method (600, 700, 800) as in claim 1, wherein curing (606, 718, 806) comprises exposing the imprintable material to heat.

3. A method (600, 700, 800) as in claim 1, wherein curing (606, 718, 806) comprises exposing the imprintable material to ultra-violet light.

4. A method (600, 700, 800) as in claim 1, wherein pressing (604, 714, 804) the imprint stamp into the imprintable material comprises aligning (716) the imprint stamp to a substrate on which the microfluidic channel is formed.

5. A method (600, 700, 800) as in claim 1, wherein depositing (602, 702, 802) an imprintable material comprises jetting (704) the imprintable material into the microfluidic channel from a fluid jetting nozzle.

6. A method (600, 700, 800) as in claim 1, wherein the imprint stamp comprises a topological channel pattern that mirrors a shape of the microfluidic channel, and wherein depositing (602, 702, 802) an imprintable material comprises depositing the imprintable material within a full length of the microfluidic channel.

7. A method (600, 700, 800) as in claim 1, wherein depositing (602, 702, 802) an imprintable material comprises:
selectively depositing (708) the imprintable material at a particular location in the microfluidic channel.

8. A method (600, 700, 800) as in claim 7, comprising jetting (710) the imprintable material into the microfluidic channel.

9. A method (600, 700, 800) as in claim 7, comprising controlling a channel length dimension of the imprintable material through:
photo curing (712) the imprintable material that has been deposited within the channel length dimension; and
washing away non-cured imprintable material that has been deposited outside of the channel length dimension.

10. A method (600, 700, 800) as in claim 1, wherein the imprintable material comprises a photo-curable liquid resist, and wherein depositing the imprintable material comprises:
jetting (802) a photo-curable liquid resist into a localized area of a microfluidic channel;
and wherein curing the imprintable material comprises applying (806) an ultra-violet light to the liquid resist until the liquid resist is cured.

11. A microfluidic channel filter comprising:
a substrate (100);
a microfluidic channel (102) formed in the substrate; and
a curable and imprintable polymer material (108) deposited in the microfluidic channel (102) and **characterized in that** the curable and imprintable polymer material (108) is imprinted with a filter pattern (106).

12. A filter as in claim 11, wherein the imprintable polymer material (108) is localized within a precise channel length dimension.

13. A filter as in claim 11, wherein the filter pattern (106) comprises a finger pattern with fingers selected from the group consisting of same-sized fingers and different-sized fingers.

14. A filter as in claim 11, wherein the substrate (100) comprises a transparent substrate to enable an ultra-violet light cure of the imprintable polymer material (108).

## Patentansprüche

1. Verfahren (600, 700, 800) zur Herstellung eines Mikrofluidkanalfilters, das Folgendes umfass:
Ablagern (602, 702, 802) eines bedruckbaren Materials in einem Mikrofluidikkanal;
Pressen (604, 714, 804) eines Prägestempels mit einem topologischen Filtermuster in das bedruckbare Material;
Aushärten (606, 718, 806) des bedruckbaren Materials; und
Entfernen (608, 720, 806) des Prägestempels von dem bedruckbaren Material, wobei das in dem bedruckbaren Material gebildete topologische Filtermuster bleibt.

2. Verfahren (600, 700, 800) nach Anspruch 1, wobei das Aushärten (606, 718, 806) ein Aussetzen des bedruckbaren Materials gegenüber Wärme umfasst.

3. Verfahren (600, 700, 800) nach Anspruch 1, wobei das Aushärten (606, 718, 806) ein Aussetzen des bedruckbaren Materials gegenüber ultraviolettem Licht umfasst.

4. Verfahren (600, 700, 800) nach Anspruch 1, wobei das Pressen (604, 714, 804) des Prägestempels in das bedruckbare Material ein Ausrichten (716) des Prägestempels auf ein Substrat umfasst, auf dem der Mikrofluidikkanal ausgebildet ist.

5. Verfahren (600, 700, 800) nach Anspruch 1, wobei das Ablagern (602, 702, 802) eines bedruckbaren Materials ein Einspritzen (704) des bedruckbaren Materials in den Mikrofluidikkanal aus einer Fluidstrahldüse umfasst.

6. Verfahren (600, 700, 800) nach Anspruch 1, wobei der Prägestempel ein topologisches Kanalmuster umfasst, das eine Form des Mikrofluidikkanals darstellt, und wobei das Ablagern (602, 702, 802) eines prägbaren Materials ein Ablagern des prägbaren Materials über die gesamte Länge des Mikrofluidikkanals umfasst.

7. Verfahren (600, 700, 800) wie in Anspruch 1, wobei das Ablagern (602, 702, 802) eines bedruckbaren Materials Folgendes umfasst:
selektives Ablagern (708) des bedruckbaren Materials an einer bestimmten Stelle in dem Mikrofluidikkanal.

8. Verfahren (600, 700, 800) nach Anspruch 7, das ein Einspritzen (710) des bedruckbaren Materials in den Mikrofluidikkanal umfasst.

9. Verfahren (600, 700, 800) nach Anspruch 7, das Folgendes umfasst:
Steuern einer Kanallängenabmessung des bedruckbaren Materials durch:
Fotohärten (712) des bedruckbaren Materials, das innerhalb der Kanallängenabmessung abgelagert wurde; und
Abwaschen von nicht ausgehärtetem bedruckbarem Material, das außerhalb der Kanallängenabmessung abgelagert wurde.

10. Verfahren (600, 700, 800) nach Anspruch 1, wobei das bedruckbare Material ein fotohärtbares Flüssigresist umfasst und wobei das Ablagern des bedruckbaren Materials Folgendes umfasst:
Einspritzen (802) eines fotohärtbaren Flüssigresists in einen lokalisierten Bereich eines Mikrofluidikkanals;
und wobei das Aushärten des bedruckbaren Materials ein Anwenden (806) von ultraviolettem Licht auf das Flüssigresist umfasst, bis das Flüssigresist ausgehärtet ist.

11. Mikrofluidikkanalfilter, das folgende Merkmale aufweist:
ein Substrat (100);
einen Mikrofluidikkanal (102), der in dem Substrat ausgebildet ist; und
ein härtbares und bedruckbares Polymermaterial (108), das in dem Mikrofluidikkanal (102) abgelagert ist und **dadurch gekennzeichnet ist, dass** das härtbare und bedruckbare Polymermaterial (108) mit einem Filtermuster (106) bedruckt ist.

12. Filter nach Anspruch 11, wobei das bedruckbare Polymermaterial (108) innerhalb einer genauen Kanallängenabmessung lokalisiert ist.

13. Filter nach Anspruch 11, wobei das Filtermuster (106) ein Fingermuster mit Fingern umfasst, die aus der Gruppe ausgewählt sind, die aus Fingern gleicher Größe und Fingern unterschiedlicher Größe besteht.

14. Filter nach Anspruch 11, wobei das Substrat (100) ein transparentes Substrat umfasst, um ein Aushärten des bedruckbaren Polymermaterials (108) mit ultraviolettem Licht zu ermöglichen.

## Revendications

1. Procédé (600, 700, 800) de fabrication d'un filtre à canal microfluidique, comprenant :
le dépôt (602, 702, 802) d'un matériau imprimable dans un canal microfluidique ;
le pressage (604, 714, 804) d'un tampon d'impression présentant un motif de filtre topologique dans le matériau imprimable ;
le durcissement (606, 718, 806) du matériau imprimable ; et
le retrait (608, 720, 806) du tampon d'impression du matériau imprimable, laissant le motif de filtre topologique formé dans le matériau imprimable.

2. Procédé (600, 700, 800) selon la revendication 1, dans lequel le durcissement (606, 718, 806) comprend l'exposition du matériau imprimable à la chaleur.

3. Procédé (600, 700, 800) selon la revendication 1, dans lequel le durcissement (606, 718, 806) comprend l'exposition du matériau imprimable à la lumière ultraviolette.

4. Procédé (600, 700, 800) selon la revendication 1, dans lequel le pressage (604, 714, 804) du tampon d'impression dans le matériau imprimable comprend l'alignement (716) du tampon d'impression avec un substrat sur lequel est formé le canal microfluidique.

5. Procédé (600, 700, 800) selon la revendication 1, dans lequel le dépôt (602, 702, 802) d'un matériau imprimable comprend l'injection (704) du matériau imprimable dans le canal microfluidique à partir d'une buse d'injection de fluide.

6. Procédé (600, 700, 800) selon la revendication 1, dans lequel le tampon d'impression comprend un motif de canal topologique qui reflète une forme du canal microfluidique, et dans lequel le dépôt (602, 702, 802) d'un matériau imprimable comprend le dépôt du matériau imprimable sur toute la longueur du canal microfluidique.

7. Procédé (600, 700, 800) selon la revendication 1, dans lequel le dépôt (602, 702, 802) d'un matériau imprimable comprend :
le dépôt sélectif (708) du matériau imprimable à un emplacement particulier dans le canal microfluidique.

8. Procédé (600, 700, 800) selon la revendication 7, comprenant l'injection (710) du matériau imprimable dans le canal microfluidique.

9. Procédé (600, 700, 800) selon la revendication 7, comprenant en outre :
la commande d'une dimension de longueur de canal à travers le matériau imprimable ;
le photodurcissement (712) du matériau imprimable qui a été déposé dans la dimension de longueur de canal ; et
le lavage du matériau imprimable non durci qui a été déposé en dehors de la dimension de longueur de canal.

10. Procédé (600, 700, 800) selon la revendication 1, dans lequel le matériau imprimable comprend une réserve liquide photodurcissable, et dans lequel le dépôt du matériau imprimable comprend :
l'injection (802) d'une réserve liquide photodurcissable dans une zone localisée d'un canal microfluidique ;
et dans lequel le durcissement du matériau imprimable comprend l'application (806) d'une lumière ultraviolette à la réserve liquide jusqu'à ce que la réserve liquide soit durcie.

11. Filtre à canal microfluidique comprenant :
un substrat (100) ;
un canal microfluidique (102) formé dans le substrat ; et
un matériau polymère durcissable et imprimable (108) déposé dans le canal microfluidique (102) et **caractérisé en ce que** le matériau polymère durcissable et imprimable (108) est imprimé avec un motif de filtre (106).

12. Filtre selon la revendication 11, dans lequel le matériau polymère imprimable (108) est localisé dans une dimension précise de longueur de canal.

13. Filtre selon la revendication 11, dans lequel le motif de filtre (106) comprend un motif digital comportant des doigts sélectionnés dans le groupe constitué de doigts de même taille et de doigts de tailles différentes.

14. Filtre selon la revendication 11, dans lequel le substrat (100) comprend un substrat transparent pour permettre un durcissement à la lumière ultraviolette du matériau polymère imprimable (108).
